# EUROPEAN PATENT SPECIFICATION

(11) **EP 2 082 858 B1**
(45) Date of publication and mention of the grant of the patent: **12.10.2016**
(21) Application number: 09151387.9
(22) Date of filing: 27.01.2009
(51) Int. Cl.: B29C 45/14, B29C 45/27

(54) **Metal mold for injection molding and semiconductor package formed therewith and method of manufacturing semiconductor package**
Metallform für den Spritzguss und Halbleiterpackung daraus und Herstellungsverfahren für die Halbleiterpackung
Moule métallique pour moulage par injection et paquet semi-conducteur formé avec celui-ci et procédé de formation du paquet semi-conducteur

(30) Priority: 28.01.2008 JP 2008016856
(43) Date of publication of application: 29.07.2009
(60) Divisional application: 16186437.6
(73) Proprietor: Nichia Corporation, Anan-shi, Tokushima 774-8601 (JP)
(72) Inventor: Yamamoto, Saiki, Anan-shi, Tokushima 774-8601 (JP)
(74) Representative: Delumeau, François Guy

(56) References cited:
- EP-A- 1 174 238
- EP-A- 1 396 891
- JP-A- 2002 292 695

## Description

### BACKGROUND OF THE INVENTION

### 1. Field of the Invention

The present invention relates to a metal mold for injection molding and a semiconductor package formed by using the metal mold, and to a method of manufacturing the semiconductor package, and, more particularly, to a metal mold for injection molding suitable for manufacturing a thin semiconductor package and the package formed by using the metal mold, and to a method of manufacturing the semiconductor package.

### 2. Description of the Related Art

Injection molding is known as a technology for manufacturing a package which is used for a semiconductor device. In injection molding, a molten resin is injected into a mold cavity through a sprue and runner and from a gate of a metal mold, and is retained for a predetermined period of time to cool and solidify to obtain a molded body. In this method, in a case where a resin molded body includes a thinner portion and a thicker portion than the rest of the molded body, the thinner portion is cooled relatively faster, so that the molten resin is cooled and solidified easily. Thus, if the thin portion where two resin flows meet is the last to be filled, a weld line tends to occur and it is more difficult for the molten resin to flow in, resulting in short shot that is incomplete filling of the mold cavity. As an improved method for eliminating such weld line and short shot, a technology such as described, for example, in JP-H07-276410A, has been proposed.

Meanwhile, for a light emitting diode (hereinafter may be referred to as "LED") used as a light source among the semiconductor devices, a light emitting element of high luminance and high optical output, and a downsized light emitting device have been developed and utilization in various fields have been performed recently. Making use of advantageous features of such as small size, low electric consumption, and light weight, such light emitting devices are used for, for example, a light source of a cell phone and liquid crystal backlight, a light source of various indicators, and various reading sensors or the like. As an example, a thinner type is required for a light source of a back light, to be used in smaller and lighter apparatus. Therefore, a light emitting device used as a light source is also needed to be smaller, and for this reason, various types of thin-type light emitting devices, called "side-view types" which emit light in a lateral direction, have been developed (for example, described in JP 2004-363537A).

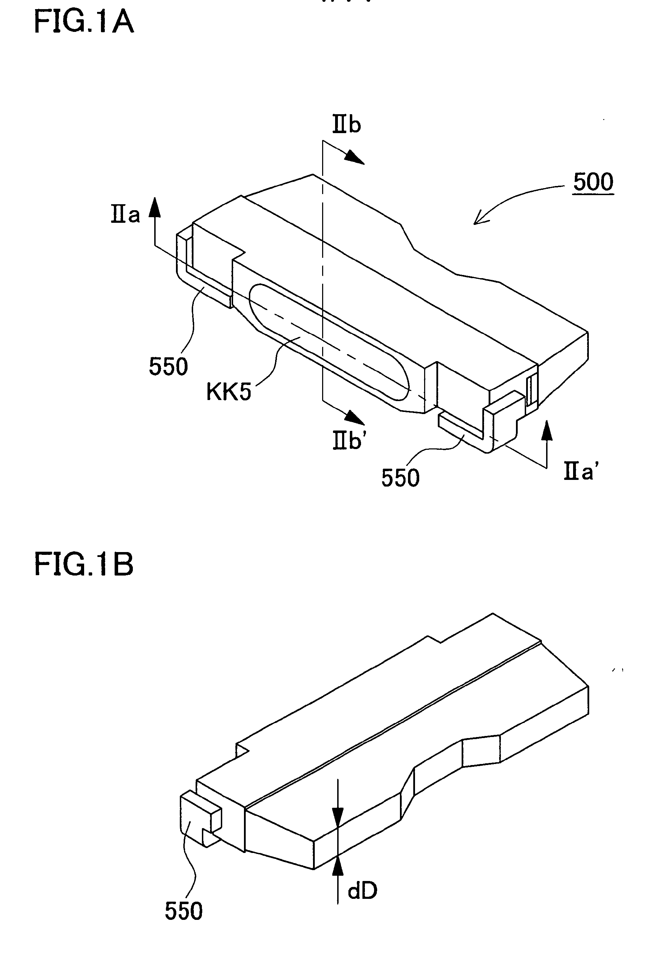

FIGS. 1 are respectively a perspective view of a side-view type light emitting device 500, the present inventor has previously developed. FIG. 1A is a perspective view as seen from diagonally front and FIG. 1B is a perspective view as seen from diagonally back. As shown in the figures, typically in a side-view type light emitting device, an opening KK5 is defined in the front side of a package to release light, and a light emitting element is mounted on the bottom surface of the opening, and a part of a lead frame is extended from the inner side of the package to outside.

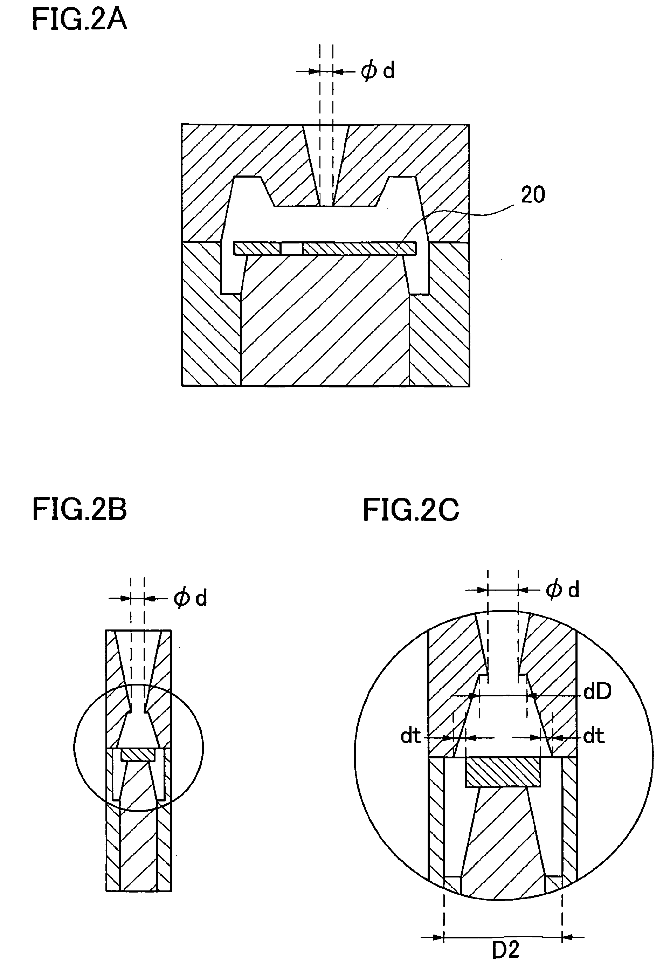

FIGS. 2 show a metal mold for molding a package of a light emitting device. FIG. 2A is a cross sectional view of the metal mold taken along line IIa-IIa' of FIG. 1A, FIG. 2B is a cross sectional view taken along line IIb-IIb' of FIG. 1A, and FIG. 2C is an enlarged cross sectional view of the gate portion of FIG. 2B. In order to form the package shown in FIGS. 1, a metal mold holding a lead frame 20 therein as shown in FIGS. 2A and 2B is used, and a molten resin is injected in the mold cavity to mold the resin. The thickness of a side-view type light emitting device is determined by the size of a dice to be mounted and the wall thickness of the package configured to house the dice. Therefore, the biggest challenge of developing the package for a side-view type light emitting device is to form a thinner wall. Accordingly, in order to obtain a thinner side-view type light emitting device, various efforts have been made on the shape and the method of manufacturing.

In order to respond to such needs for smaller and thinner semiconductor devices including such light emitting devices, and to conform to complicated shapes, the molding of the packages that dominates the size of the external shape of the semiconductor device is greatly relied on. For this reason, designing of a metal mold for resin molding adapted for the formation of a thinner molded product has been required. However, if the production of a thinner product is attempted by metal molding, occurrence of a weld line and/or short-shot is difficult to avoid. A method such as disclosed in JP H07-276410A described above is effective for forming a relatively large molded product such as a wheel cover of a car. However, this method may produce an opposite effect, particularly when semiconductor packages, which are small in size, are to be formed. Also, there are cases in which provision of two or more gates which are the entrance of resin flow, may be difficult.

Moreover, as described above, the thinner the wall of the package, the faster the molten resin will cool and solidify, so that occurrence of a weld line and short shot will increase. Specifically with reference to FIGS. 1 and FIGS. 2, the back surface of the package of FIG. 1B has a tapered shape narrowing from the front flat surface toward the back, so that the end surface of the tapered surface that is the thickness dD of the back surface is the thinnest portion. Therefore, in order to mold the shape shown in FIG. 1, the inner diameter that is the gate diameter Ød of the gate through which the molten resin to be injected in the metal mold shown in FIGS. 2A to 2C, is needed to be smaller than the thickness dD of the back surface, as shown in the enlarged view of FIG. 2C. However, in order to form a thinner package, the thickness dD of the back surface is needed to be reduced, resulting in a reduction in the gate diameter Ød, as the diameter is limited by the thickness dD. When the gate diameter Ød is reduced, the molten resin is difficult to fill into the cavity of the metal mold uniformly. Particularly, the thickness dt at the end portion of the lead frame located at the boundary between the tapered surface and the flat surface is extremely small, so that delivery of the resin, which is to define the opening portion of the package, into the mold cavity through the narrow portion is not easy, and a weld line and short shot tend to occur. To avoid such an occurrence, measures can be considered such as increasing the injecting speed of the molten resin and/or increasing the holding pressure after filling the resin. However, in this case, the pressure in the mold cavity increases, so that the resin may move in the gaps between the metal mold members, resulting in generation of unacceptable level of resin burrs. Further, if the molten resin is injected into the mold cavity under a high pressure, the resin may adhere to the metal mold. Then, when the mold is opened after solidifying the resin, the resin molded portion may be sheared off with the separation of the mold members. Therefore, if a mold is designed to overcome all of the above problems, the achievable reduction of the wall thickness of the package is limited. Once the limit of the package wall thickness is determined, the dice size is also needed to be reduced to be complied therewith. However, under the conditions of the size and applied voltage that are required particularly for a side view type light emitting device, the luminescence of the device decreases as the dice size decreases. That is, the thicker the package wall, the dimmer the product of the light emitting device becomes. Further prior art molds are disclosed in EP1396891, JP2002292695 and EP1174238.

In view of the foregoing problems, the resent invention has been devised. A primary object of the present invention is to provide a metal mold for injection molding, a semiconductor package by using the mold, and a manufacturing method of the semiconductor package capable of facilitate the manufacture of a semiconductor package of advancing downsizing and increasingly complex structures, and exhibiting highly excellent performance with an external shape requested by client.

### SUMMARY OF THE INVENTION

In order to solve the above problems, , a metal mold for resin injection molding has a fixed mold member and a plurality of movable mold members each having inner surface capable of collectively defining a mold cavity upon closing thereof, to enable an injection molded semiconductor package to be obtained by injecting a resin into the mold cavity defined by closing the fixed mold member and the movable mold members. The fixed mold member or the plurality of movable mold members has a gate formed continuous to the inner surface thereof to inject a resin into the mold cavity. The inner surface of the plurality of the movable mold members has a first mold surface and a second mold surface which are disposed facing each other and tapering toward the gate, and a recess can be defined in the first mold surface or the second mold surface at a portion to be in contact with the gate. With this arrangement, a large gate opening can be employed so that the molten resin can be supplied into the mold cavity even under a lower internal mold pressure. Accordingly, generation of burrs can be prevented and stable resin molding can be achieved.

In the metal mold for resin molding according to the present invention, a lead frame can be placed between the fixed mold member and the movable mold members, and the narrowest gap between the end surface of the lead frame and the inner surfaces of the movable mold surfaces can be one fourth or less of the height of the mold cavity defined by the movable mold member.

In a further particular embodiment, a nesting member can be arranged in the mold cavity of the movable mold member side.

The nesting member can be arranged such that the shortest distance between the inner surfaces of the movable mold members and the nesting member is 0.1 mm or less.

According to further aspects of the present invention, the latter also relates to a method of forming semiconductor packages by using metal molds for injection molding according to claim 1, as well as semiconductor packages thus obtained.

According to a further aspect of the present invention, a semiconductor package is provided, which is mounted with a semiconductor component and has a package upper surface and a package lower surface, and a package front surface and a package back surface facing each other respectively. The package front surface and the package back surface are adjacent to the package upper surface and the package lower surface respectively. The package upper surface and the package lower surface are disposed so that the thickness of the package decreases from the package front surface side toward the package back surface side. A protrusion can be formed on the package lower surface so as to be continuous with the package back surface. With this arrangement, the gate diameter can be made larger, so that a semiconductor package which is small and capable of suppressing generation of burrs, and has a good productivity, can be obtained. Moreover, a protrusion protruding from the lower surface of the package can be formed on the surface of the semiconductor package, so that unexpected inclination that may occur upon mounting of the semiconductor package can be prevented.

In a particular embodiment of a semiconductor package according to the present invention, the maximum thickness of the semiconductor package at a portion where the protrusion has been provided can be substantially equal to or less than the maximum thickness of the package at the package front surface side.

In a further particular embodiment of a semiconductor package according to the present invention, the semiconductor package can be configured such that a step portion is formed by defining a recess approximately in the center of the package back surface, and the protrusion is formed protruding from the bottom surface of the recess step and the top of the protrusion is fit within the recess step.

In a further particular embodiment of a semiconductor package according to the present invention, the semiconductor package further includes a package body defining a recess, a pair of external electrodes having one end portion exposed in the recess and the other end portion protruding from the surface of the package body and being bent along the surface of the package body, and a semiconductor light emitting element housed in the recess and connected with the pair of external electrodes, so that the semiconductor package can construct a semiconductor light emitting device.

According to a further aspect of the invention, a method is provided for manufacturing a semiconductor package having a package upper surface and a package lower surface formed tapered from the front side of the package toward the back side of the package, the method including a step of disposing a lead frame of a semiconductor package at a predetermined position between the fixed mold member and the movable mold members facing the fixed mold member, a step of defining a mold cavity by closing the mold members, in which the fixed mold member defines a gate opened toward the back side of the package for injecting a molten resin into the metal mold, the diameter of the gate in the thickness direction of the semiconductor package is larger than the maximum thickness of a portion of the package where the gate is not provided, and the diameter of the gate is approximately equal to or less than the maximum thickness of the package at the front side, a step of filling the molten resin into the mold cavity from the gate, from the fixed mold member toward the movable mold members, and a step of releasing the molded product after solidifying the molten resin. With this arrangement, a large gate opening can be employed so that the molten resin can be supplied into the cavity even under a lower internal mold pressure. Accordingly, generation of burrs can be prevented and stable resin molding can be achieved.

The above and further objects of the present invention as well as the features thereof will become more apparent from the following detailed description to be made in conjunction with the accompanying drawings.

### BRIEF DESCRIPTION OF THE DRAWINGS

FIG. 1A is a perspective view of a side view type light emitting device as seen from diagonally front, which is developed by the applicant earlier;
FIG. 1B is a perspective view of a side view type light emitting device as seen from diagonally back, which is developed by the applicant earlier;
FIG. 2A is a cross sectional view taken along line IIa-IIa' in FIG. 1A of metal mold for resin molding a package of a light emitting device the applicant earlier developed;
FIG. 2B is a cross sectional view taken along line IIb-IIb' in FIG. 1A;
FIG. 2C is a partially-enlarged cross sectional view of the gate portion in FIG. 2B;
FIG. 3 is a perspective view of a semiconductor package according to Embodiment 1 of the present invention as seen from diagonally above of the front side;
FIG. 4 is a perspective view of the semiconductor package of FIG. 3 as seen from diagonally below of the front side;
FIG. 5 is a perspective view of the semiconductor package of FIG. 3 as seen from diagonally above of the back side;
FIG. 6 is a perspective view of the semiconductor package of FIG. 3 as seen from diagonally below of the back side;
FIG. 7A is a front view of the semiconductor package of FIG. 3;
FIG. 7B is a back view of the semiconductor package of FIG. 3;
FIG. 7C is a partially cross sectional side view of the semiconductor package of FIG. 3;
FIG.8 is a side view of a semiconductor package which is developed by the applicant earlier;
FIG. 9 is a side view of the semiconductor package in which the opening portion of the semiconductor package of FIG. 8 is shallower;
FIG. 10 is a side view illustrating a state the semiconductor package of FIG. 9 is mounted at angle;
FIG. 11 is a schematic side view of a semiconductor package according to Embodiment 1 of the present invention;
FIG. 12 is a perspective view of a semiconductor package according to Embodiment 2 of the present invention as seen from diagonally above of the front side;
FIG. 13 is a perspective view of the semiconductor package of FIG. 12 as seen from diagonally below of the front side;
FIG. 14 is a perspective view of the semiconductor package of FIG. 12 as seen from diagonally above of the back side;
FIG. 15 is a perspective view of the semiconductor package of FIG. 12 as seen from diagonally below of the back side;
FIG. 16 is an exploded perspective view showing a structure of a metal mold for injection molding;
FIG. 17 is a sectional perspective view of the fixed mold member in FIG. 16 taken along line XVII-XVII';
FIG. 18 is a sectional view taken along line XVIII-XVIII' of FIG. 16;
FIG. 19 is a sectional view showing a state where the resin has been filled in the cavity of FIG. 18;
FIG. 20 is a perspective view of a semiconductor package in which the resin has been solidified, as seen from diagonally below of the metal mold;
FIG. 21A is a sectional view of the metal mold for injection molding in FIG. 20 taken along line XXIa-XXIa'; and
FIG. 21B is a sectional view of the metal mold for injection molding in FIG. 20 taken along line XXIb-XXIb'.

### DETAILED DESCRIPTION OF THE EMBODIMENT(S)

### Embodiment 1

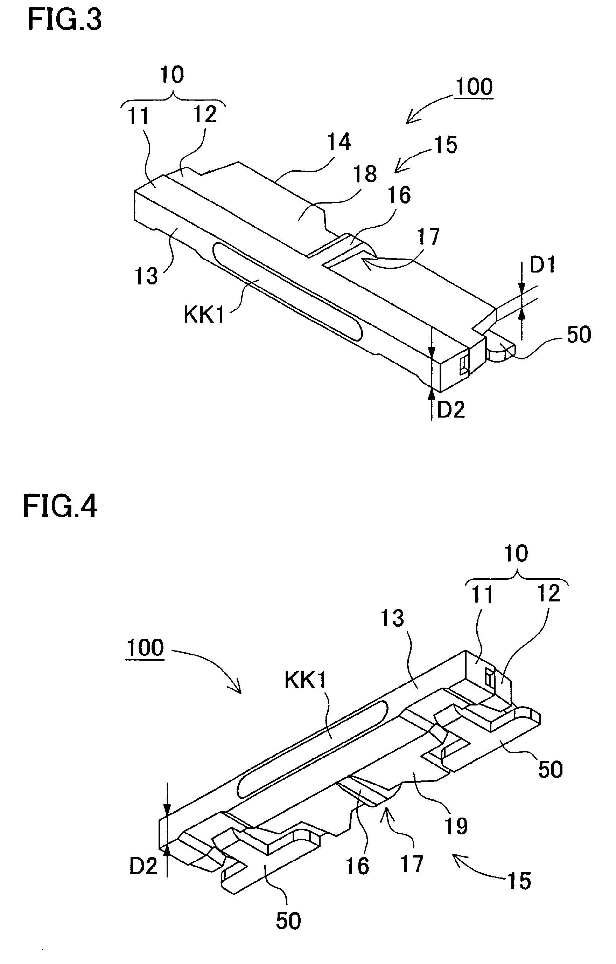

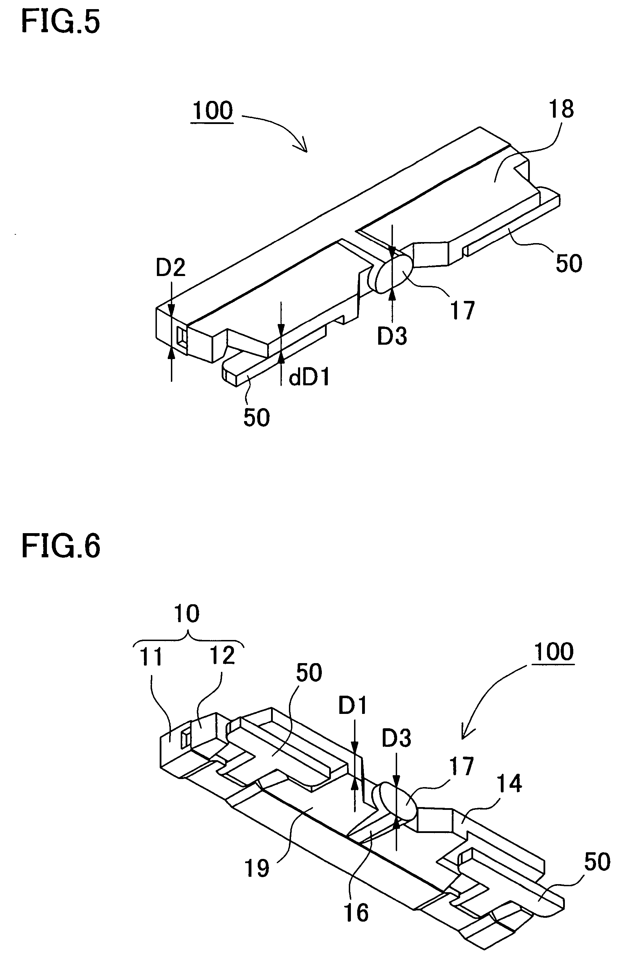

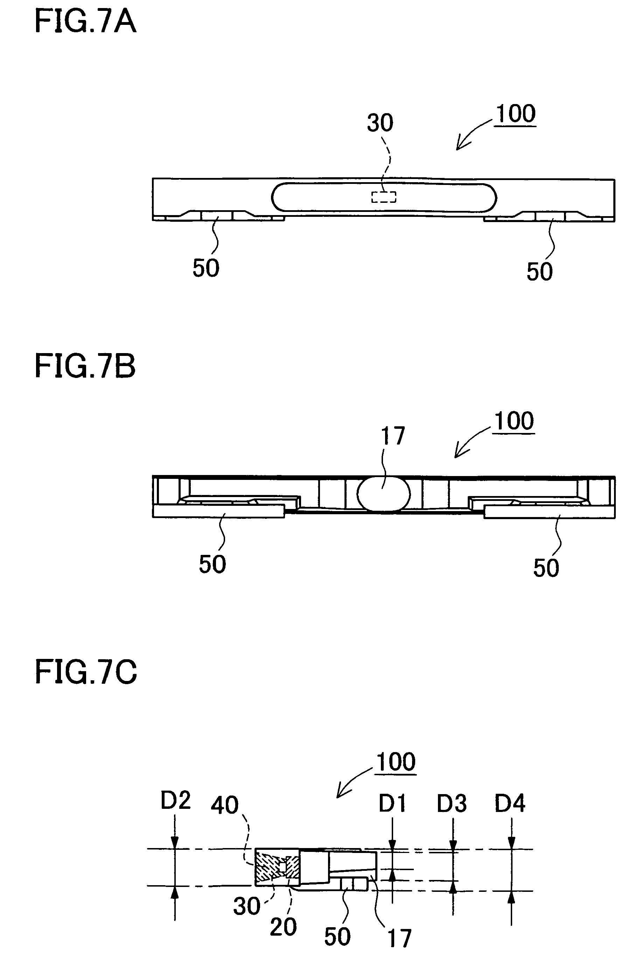

FIG. 3 to FIG. 7 show external shapes of the semiconductor package 100 according to Embodiment 1 of the present invention. In these figures, FIG. 3 is a perspective view of the semiconductor package 100 as seen from diagonally above of the front side, FIG. 4 is a perspective view as seen from diagonally below of the front side, FIG. 5 is a perspective view as seen from diagonally above of the back side, FIG. 6 is a perspective view as seen from diagonally below of the back side, FIG. 7A is a front view, FIG. 7B is a back view, and FIG. 7C is a partially cross sectional side view box-shape block member 11 (front side of the package), respectively. The semiconductor package 100 shown in these figures is a side-view type light emitting device using a semiconductor light emitting element 30 includes a package body 10 which is resin molded with the thickness smaller than the width, and a pair of positive and negative electrodes 50 extended outside of the package body 10.

### (Lead Frame 20)

A lead frame 20 is disposed in the package body 10 formed integrally with the package body 10 by way of such as a resin molding so that the upper surface of the lead frame 20 that is the semiconductor mounting surface is exposed at the bottom surface of the opening KK1 which will be described below. In addition, a part of the lead frame exposed outside of the package body 10 will serve as an external electrode 50.

It is sufficient that the lead frame 20 has a substantially planar shape, and a corrugated planar shape or a planar shape with uneven surface may also be employed. The thickness thereof may either be uniform or has a thicker portion or a thinner portion. The material for the lead frame 20 is not particularly limited and a material having a relatively high thermal conductivity is preferably used. When the lead terminal is made of such material, heat generated in the semiconductor light emitting element can be transferred and released to outside efficiently. For example, for a semiconductor device, it is preferable that the material has a thermal conductivity of about 200 W/(m·k) or greater, or a relatively high mechanical strength, or that a punching press processing or etching processing can be performed easily with the material. Specific examples thereof include metals such as copper, aluminum, gold, silver, tungsten, iron, and nickel, and alloys such as iron-nickel alloy, and phosphorus bronze. In addition, for a light emitting device mounted with a light emitting element 30, reflective plating is preferably provided on the surface of the lead frame 20 in order to efficiently extract light from the light emitting element 30 to be mounted. A semiconductor element can also be mounted directly on a surface of the package body without using a lead frame as its mounting surface.

### (Semiconductor Element)

A semiconductor light emitting element 30 such as LED and LD (Laser Diode) can be suitably used as a semiconductor element. A semiconductor such as ZnS, SiC, GaN, GaP, InN, AlN, ZnSe, GaAsP, GaAlAs, InGaN, GaAlN, AlInGaP, or AlInGaN is grown as a light emitting layer on a substrate by way of liquid phase deposition, HDVPE, or MOCVD. From ultraviolet light to infrared light, various wavelengths of emission can be selected according to the materials and the mixed crystal ratio of the semiconductor layer. Examples of the material for the light emitting layer include In_{X}Al_{Y}Ga_{1-X-Y}N (0≤X≤1, 0≤Y≤1, X+Y≤1). A light emitting element can be obtained by combining such a light emitting element with various fluorescent materials each emits light having a different wavelength from the emission wavelength of the light emitting element. For the material of a red light emitting element, a gallium-aluminum-arsenide semiconductor and an aluminum-indium-gallium-phosphide semiconductor are preferably selected. For a color display device, it is preferable to use a combination of the light emitting elements including a red light having a wavelength of 610 nm to 700 nm, a green light having a wavelength of 495 nm to 565 nm, and a blue light having a wavelength of 430 nm to 490 nm.

The light emitting element 30 is electrically connected to an external electrode 50 which supplies electric power to the light emitting element 30. The number of the light emitting element 30 to be mounted is either one or plural. In this case, a combination of a plurality of light emitting element having the same emission color may be used to improve luminosity. Further, color reproduction can be enhanced by combining a plurality of light emitting elements that emit light of different colors to correspond to RBG, for example.

In addition, if needed, a wavelength converting member may be disposed around the light emitting element so that light from the light emitting element can be converted to a light having different wavelength and emitted. The wavelength converting member is formed by, for example, mixing a fluorescent material which is excited by light from the light emitting element and emits fluorescent light with a light transmissive resin. With this arrangement, light from the light emitting element can be converted by the wavelength converting member into light having a longer wavelength, so that mixed light of the light from the light emitting element and the light having a longer wavelength that is the converted light can be extracted outside.

Further, the element to be mounted is not limited to the light emitting elements, and variety of semiconductor elements such as a photoelectric conversion element such as a PD (photodiode), and a light receiving element, an image sensor such as a CCD, a C-MOS, a CdS cell, and a PSD (position sensitive detector), a photoelectric sensor can be employed.

### (Mounting of Semiconductor Element)

The semiconductor element such as the light emitting element 30 is fixed onto a surface of the package body 10 or a surface of the lead frame 20 formed by using the metal mold for injection molding 60 (described later) through a bonding member. For example, when the light emitting element 30 is formed by growing a nitride semiconductor on a sapphire substrate and emits a blue-to-green light, an epoxy resin, a silicone resin and the like can be used as a bonding member. In addition, in view of deterioration due to light and heat from the light emitting element 30, an Al plating may be applied on the back surface of the light emitting element, and a solder such as Au-Sn eutectic, a brazing filler metal such as a low melting temperature metal, a conductive paste can be used as a bonding material. Moreover, when the light emitting element is made of such as GaAs and emits a red light, and having an electrode disposed on the both sides thereof, die bonding can be applied by using a conductive paste such as silver, gold, palladium.

### (Flip-chip Bonding or Wire Bonding)

Electric connection of the light emitting element 30 and the lead frame 20 can be established by flip-chip mounting (face-down mounting) using a conductive member or face-up mounting using a conductive wire.

Examples of the conductive member for flip-chip mounting include a metal bump such as Au, a solder such as Au-Sn eutectic, an anisotropically conductive material, and a conductive paste such as Ag. It is preferable that the conductive wire forms good ohmic contact and good mechanical contact with the electrodes of the light emitting element, and has good electric conductivity and heat conductivity. The heat conductivity is preferably approximately 0.01 cal/S·°C/cm² or higher, and more preferably approximately 0.5 cal/S·°C/cm² or higher. In view of workability or the like, the diameter of the conductive wire is preferably in a range of about 10 µm to about 45 µm. Examples of the materials for the conductive wire include metals such as gold, copper, platinum, and aluminum, and alloys thereof.

### (External Electrode 50)

As each external electrode 50, a portion of the lead frame 20 is used as the external electrode 50 such that a portion of the external electrode is buried in the package body 10 by insert molding and the like, and the exposed part portion thereof is bent. As shown in FIG. 6, when the outer shape of the exposed portion is formed in an approximately T-shape, the T-shape portion serves as the bonding surface when the semiconductor package 100 is mounted. In this example, two external electrodes 50 are provided, but according to the number and kind of the element to be mounted, three or more external electrodes can be provided. In this case, the external electrode may also be disposed on the bottom surface of the box-shaped block 11 (described later). In addition, the outer shape of the exposed portion is not limited to the T-shape and appropriately changed to any shapes as long as it serves as the bonding surface as described above.

### (Covering Material 40)

When the semiconductor element has been mounted in the opening KK1, the opening is preferably filled with a covering material 40 to mold (see FIG. 7C etc.). With this arrangement, for example, in a case of the light emitting element, in addition to the light emitting element 30, the conductive wires are protected from external force, moisture, or the like. The covering material is preferably light transmissive. Examples of the encapsulation resin which can be used for such a covering material 40 include a transparent resin or glass having excellent weather resistance such as an epoxy resin, a silicone resin, an acrylic resin, a urea resin. Particularly, if a transparent resin is employed, even in a case where water is absorbed into the light transmissive covering material during the manufacturing steps or storage, the water contained into the resin can be released into the ambient air by conducting a baking at 100 °C for 14 hours or longer. Accordingly, damage caused by the moisture and detachment of the light emitting element and the mold member can be prevented.

Filler, a scattering material, or a diffusing material may be dispersed in the encapsulation resin. Further, a wavelength converting layer mixed with a wavelength converting member such as a fluorescent material can be provided. A diffuser is an agent that diffuses light, and serves to lessen directionality from the light emitting element and to widen the viewing angle. A fluorescent material is one that converts light from the light emitting element, and is able to convert the wavelength of light emitted from the light emitting element to the outside of the package. In a case where the light from the light emitting element is visible light with a short wavelength and high energy, a perylene derivative, which is an organic fluorescent material, or an inorganic fluorescent material such as ZnCdS:Cu, YAG:Ce, or nitrogen-containing CaO-Al₂O₃-SiO₂ activated with Eu and/or Cr, various fluorescent materials are suitably used. In a case where a white light is to be obtained with a light emitting device, particularly when a YAG:Ce fluorescent material is used, depending on the content thereof, a part of light from a blue light emitting element is absorbed to emit a yellow light which is a complementary color thereof, and with light from the blue light emitting element, a white light can be produced relatively simply and with good reliability. Similarly, when nitrogen-containing CaO-Al₂O₃PSiO₂ fluorescent material activated with Eu and/or Cr is used, depending on the content thereof, a part of light from a blue light emitting element is absorbed to emit a red light which is a complementary color thereof, and with light from the blue light emitting element, a white light can be produced relatively simply and with good reliability. Also, color unevenness can be reduced by completely precipitating the fluorescent material and removing bubbles.

### (Package Body 10)

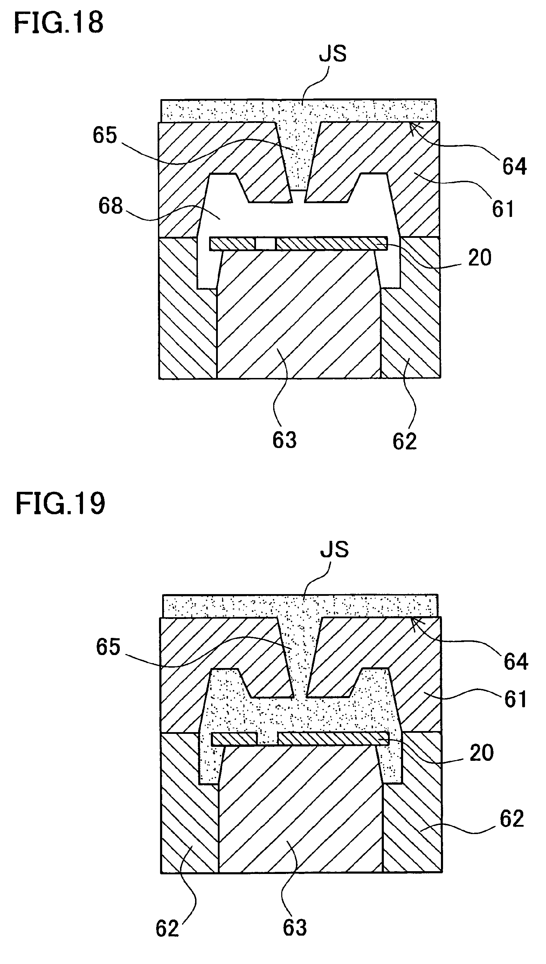

The package body 10 may be formed by filling a molten resin JS into the metal mold (see FIG. 18 and FIG. 19). For such a resin material, one capable of integrally forming the lead frames 20 and of ensuring insulation of the semiconductor element and the lead frames 20 can be used appropriately. Examples thereof include thermoplastic resins and thermosetting resins, specifically, polyphthalamide (PPA), polycarbonate resin, polyphenylene sulfide (PPS), liquid crystal polymer (LCP), ABS resin, epoxy resin, phenol resin, acrylic resin, PBT resin, and other such resins, and ceramics. Thermoplastic resins are suitably used.

Such a resin JS may be a composite in which an appropriate reinforced filler is blended.
Examples thereof include fiber-reinforced composites containing typically glass fiber, or containing carbon fiber, polyamide fiber, potassium titanate fiber, plaster fiber, brass fiber, steel fiber, ceramic fiber, boron whisker, or the like, and other inorganic filler-reinforced composites containing asbestos, mica, talk, silica, calcium carbonate, glass, clay, wollastenite, titanium oxide, or the like, in various shapes such as a powder shape, a particle shape, a plate shape, a flake shape, a bead shape, or the like.

In the package body 10, an opening KK1 is defined in the front surface side 13 where the light emission surface is provided, and a semiconductor light emitting element 30 is mounted on the bottom surface of the opening KK1. The positive electrode and the negative electrode of the semiconductor light emitting element 30 are electrically connected with the positive electrode and the negative electrode of the external electrodes 50 respectively. The opening KK1 is defined by inclined side walls broadening toward the opening edge.

In addition, as shown in FIG. 3 and FIG. 6, the package body 10 is such that the front surface 13 side is formed with a box-shaped block 11 having its upper surface and lower surface approximately in parallel, and the back surface 14 side is formed with a inclined block 12 having a tapered surface 15 narrowing from a middle portion toward the back surface 14. For this, the thickness D1 of the back surface 14 is formed smaller than the thickness D2 of the front surface 13. Also, on the back surface 14 side, a projection 17 is formed with a thickness larger than the thickness D1 of the back surface 14 and approximately the same as or smaller than the thickness D2 of the front surface 13. Here, the term "inclined tapered surface 15" indicates the upper side tapered surface 18 and the lower side tapered surface 19 and the upper tapered surface 18 and the lower tapered surface 19 are formed opposite to each other. In other words, the package body 10 is formed such that the thickness thereof is gradually decreased from the front surface 13 side to the back surface 14 side, and a projection 17 is formed continuous to the back surface 14 on the upper side tapered surface 18 or the lower side tapered surface 19. (The above includes the case where the projection 17 is formed on both the upper tapered surface 18 and the lower tapered surface 19.))

Described below is a reason for including a case in which the thickness D3 of the projection 17 and the thickness D2 of the front surface 13 are approximately the same. In a case where the thickness D3 of the projection 17 is greater than the thickness D2 of the front surface 13, the projection protrudes further than the bottom surface of the box-shaped block member 11 of the package body 10, but in practice, in order to facilitate the mounting of the external electrodes 50, the bottom surface of the external electrodes 50 are designed to protrude further than the bottom surface of the box-shaped block member 11. Therefore, as shown in FIG. 7C, the thickness D4 of the semiconductor package 100 is greater than the thickness D3 of the projection 17. Thus, the projection 17 would not impede the mounting as long as the projection 17 does not protrude greater than the bottom surface of the mounting side of the external electrodes 50. Therefore, it would be acceptable even in a case where the thickness D3 of the projection 17 is greater than the thickness D2 of the front surface 13, if the difference therebetween is smaller than the difference in height (that is, D4-D3) between the bottom surface of the external electrodes 50 and the bottom surface of the box-shaped block member 11. Therefore, the expression the thickness D3 of the projection 17 and the thickness D2 of the front side 13 are "approximately the same" includes a case where the difference in the thickness is in a range described above (D4-D3), even if the thickness D3 of the projection 17 is thicker than the thickness D2 of the front surface side 13.

On a tapered surface 15 of the inclined block member 12, a tapered projecting surface 16 is formed with the thickness being gradually increased from the back surface side 14 toward the front surface side 13, that is more gradual than the inclination of the tapered surface of the inclined block member 15, so as to be continuous from the position where the projection 17 is formed. The tapered projection surface 16 is not formed in the box-shaped block 11. Accordingly, the projection 17 is formed protruded on the tapered surface of the inclined block member 12 to the border between the inclined block member 12 and the box-shaped block member 11. In the figures, the tapered surface of the protrusion 16 is formed on the projection portion 17, but such an inclined flat surface is not essential. A flat surface without being tilt and approximately coplanar with the box-shaped block 11 or a surface in parallel with and a step lower than the box-shaped block member 11, or the top portion of the projection may be curved.

A step is formed in the end portion of the back surface 14 side of the package 10, by providing a recess in the center portion of the inclined block member 12. Also, the top portion of the projection is arranged within the recess-shaped step. With this arrangement, even if the projection 17 protrudes to some degree from the bottom surface of the center portion in the resin injecting direction (gate direction), the protrusion can be prevented from protruding out the back surface 14 of the package body 10, so that increasing in the size of the semiconductor package can be avoided.

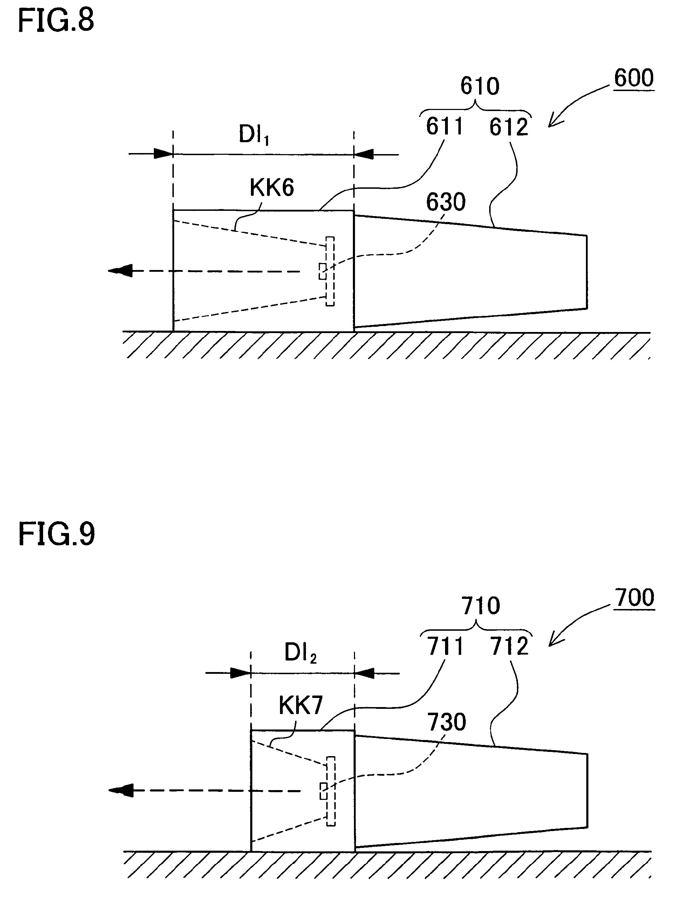

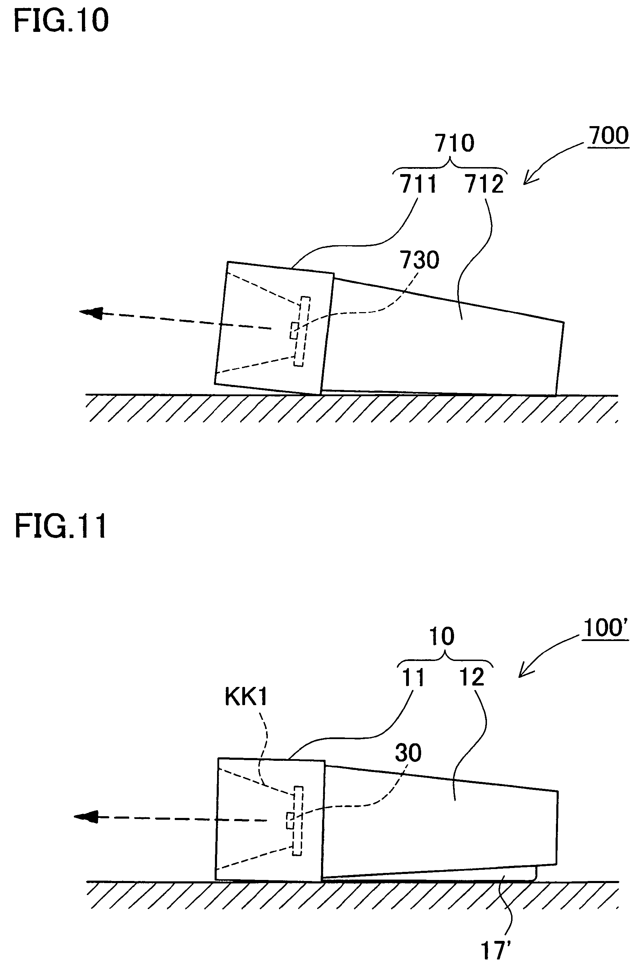

Such a protrusion 17 is advantageous in improving the stability and reliability upon mounting the semiconductor package. Typically, a semiconductor package is formed with a part in a box-shaped block member 11 and another part with an inclined block member 12 to facilitate ejection of the molded product from the mold. FIG. 8 shows a side view of a light emitting device using such a semiconductor package 600. Typically, in a side-view type light emitting device, the package body 610 is formed with a box-shaped block member 611 having the depth DI1 and an inclined block member 612. A semiconductor light emitting element 630 such as an LED is arranged at the bottom of a recess defined in the opening KK6 which opens toward the box-shaped block member 611 side. A part of light emitted from the semiconductor light emitting element 630 is reflected at the side surfaces defining the recess and extracted outside. Recent years, in order to obtain a thin wall, the package body 710 is preferred to have a shallower recess-shaped opening KK7 as the semiconductor package 700 shown in FIG. 9, that is a package body 710 having a structure in which the depth DI2 of the box-shaped block 711 is reduced. However, the center of gravity shifts backward in such a structure, so that the package tends to lean backward as shown in FIG. 10, that is, the bottom portion of the inclined block member 712 tends to rest on its end. If a light emitting element 730 is mounted in such a position that light from the side-view type light emitting device cannot be emitted correctly in lateral direction and generates error in irradiating direction, resulting in degradation in the production yield.

In contrast, in the semiconductor package 100' as shown in FIG. 11, the projection 17' is provided on the lower surface side of the inclined block member 12. Therefore, even if the package leans backward, the inclination angle can be minimized and thus contributes to improving the manufacturing yield. As described above, the projection can serve as a support when the light emitting device inclines, so that the irradiating direction can be stabilized at the time of mounting.

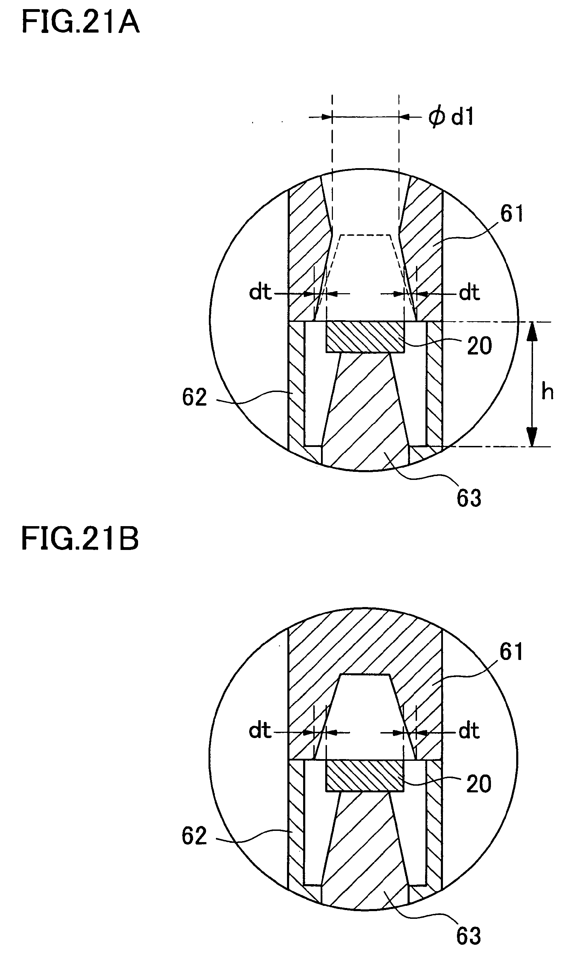

In the example of the semiconductor package 100 shown in FIG. 3 and FIG. 6, such a projection is formed in the upper and lower surfaces of the inclined block member, respectively. Also, as in the semiconductor package 100' shown in FIG. 11, the projection 17' may be formed only in the lower surface side. The projection may also be formed only in the upper surface side. Even if the projection is formed only in either the upper surface or the lower surface, a larger gate diameter Ød1 (see FIGS. 21) can be allowed in the metal mold for resin molding used to obtain a resin-molded package body 10. Also, adding a protrusion provides an advantage for stabilization because the center of gravity of the package body sifts backward. In a case where the projection is formed on the upper surface side, it is advantageously used as a positioning member upon mounting the semiconductor package.

### Embodiment 2

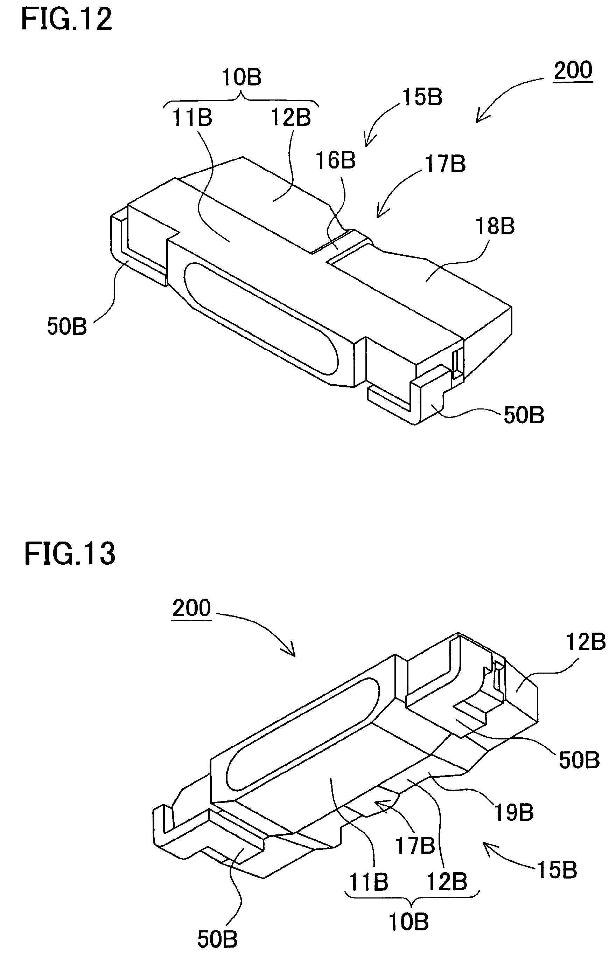

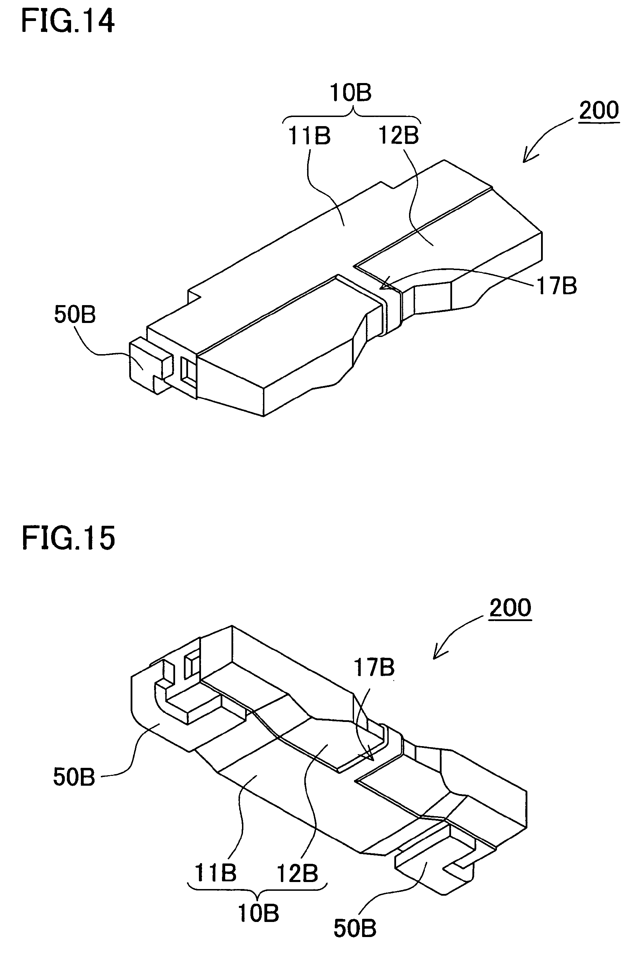

The shape of the semiconductor package is not limited to the ones described above and various shapes can be employed. As an example, examples of the semiconductor package 200 are shown in FIG. 12 to FIG. 15 as Embodiment 2, with the external electrodes having different shapes. In there figures, FIG. 12 is a perspective view of a semiconductor package 200 as seen from diagonally above of the front side, FIG. 13 is a perspective view as seen from diagonally below of the front side, FIG. 14 is a perspective view as seen from diagonally above of the back side, and FIG. 15 is a perspective view as seen from diagonally below of the back side, respectively. The semiconductor packages 200 shown in the figures are also of side-view type light emitting devices as in Embodiment 1 using a semiconductor light emitting element, similar reference numerals are used to denote like members and a repetition of a detailed description of the same members will be omitted. That is, a projection 17B having a tapered projection surface 16B is formed on both the upper tapered surface 18B and the lower tapered surface 19B of the tapered surface 15B of the inclined block member of the package body 10B. The external electrodes 50B exposed from the package body 10B are, as shown in FIG. 13 and the like, disposed in the box-shaped block 11B side and not in the inclined block 12B side. That is, the external electrodes 50 protruded from the side surfaces of the box-shaped block 11B are respectively bent along from the side surface to the bottom surface thereof. With this arrangement, the external electrodes are not disposed in the inclined block member 12B side, so that a depth of the inclined block 12B can be reduced compared with Embodiment 1. At the same time, the shorter the depth of the inclined block member 12B, the larger the angle of inclination will be when the portion is grounded. Also, the probability of the packages being grounded at angle increases. Therefore, such a structure having a protrusion which supports the inclined block member is further advantageous.

In the package body 10B, the projection 17B formed on the inclined block member 12B is formed extended on the lower tapered surface 19B, so that the projection 17B of the box-shaped block member 11B is arranged closer to the bottom surface (in this embodiment, the bottom surface of the box-shaped block member 11B) of the package body 10B.

When the above semiconductor package is mounted, for example, according to the amount of the solder paste used in the mounting, the lower tapered surface 19B of the bottom surface side of the inclined block member 12B may be grounded to the mounting surface. Even in this case, the closer the bottom surface of the inclined block member 12B to the bottom surfaces of the external electrodes 50B which is intended to be grounded to the mounting surface, the less error in irradiating direction will be. As described above, according to Embodiment 2, the projection 17B is projecting downwardly, so that even if the package is mounted at an angle, the inclined angle can be minimized, and error in irradiating direction can be suppressed to minimum.

As described above, in a case where the external electrodes are bent toward the light emitting surface side, irradiating direction upon the mounting of the light emitting device can be stabilized.

### (Metal Mold for Injection Molding 60)

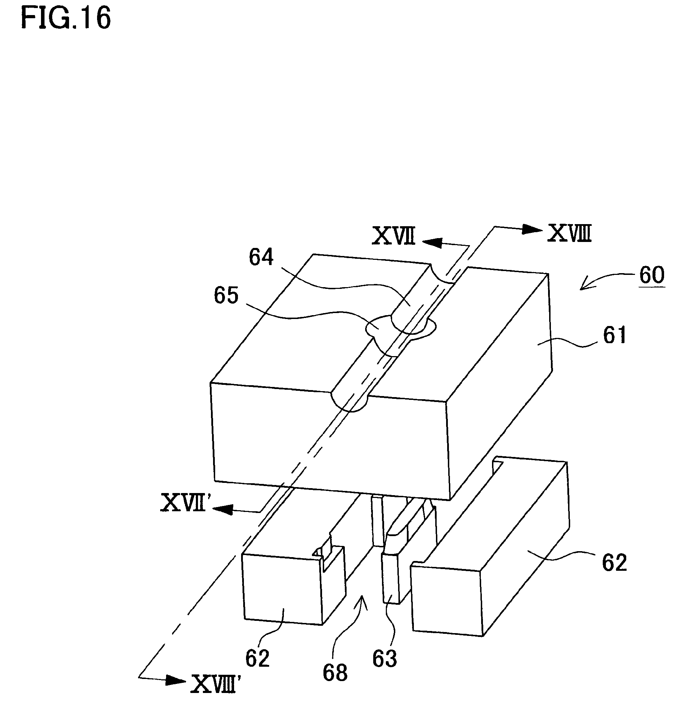

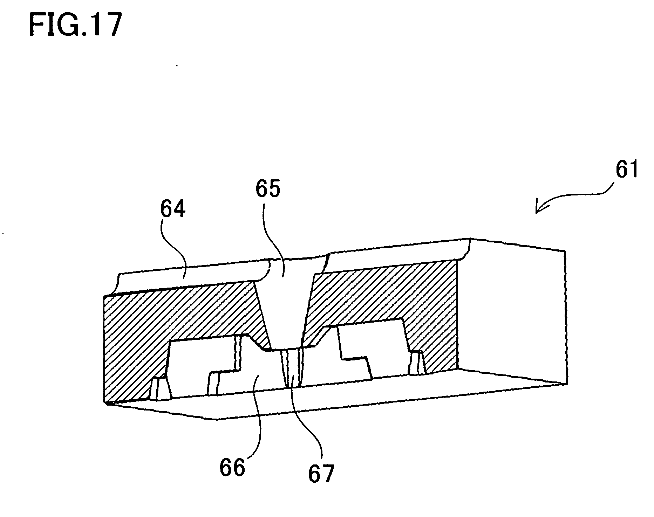

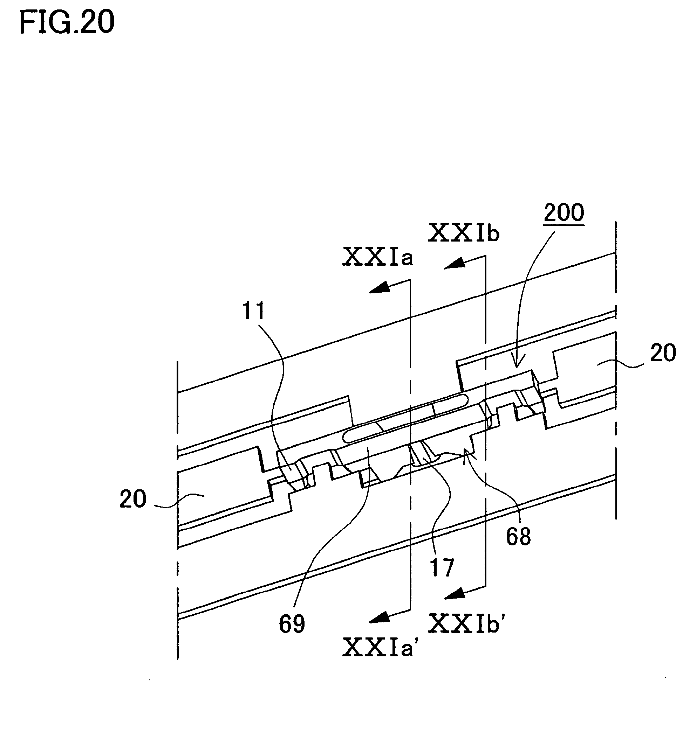

Next, FIG. 16 to FIG. 21 illustrate a structure of the metal mold used for injection molding the semiconductor packages 100 according to Embodiment 1 shown in FIG. 3 to FIG. 15. In the figures, FIG. 16 is an exploded perspective view of a metal mold for injection molding, FIG. 17 is a sectional perspective view of the fixed mold member 61 in FIG. 16 taken along line XVII-XVII', FIG. 18 is a sectional view taken along line XVIII-XVIII' of FIG. 16, FIG. 19 is a sectional view showing a state where the resin has been filled in the mold cavity of FIG. 18, FIG. 20 is a perspective view of a semiconductor package in which the resin has been solidified, as seen from diagonally below of the mold, FIGS. 21 are sectional views of a metal mold for injection molding in which FIG. 21A shows a sectional view taken along line XXIa-XXIa' of FIG. 20, and FIG. 21B shows a sectional view taken along line XXIb-XXIb' of FIG. 20, respectively. The metal mold for injection molding 60 shown in the figures is constructed with a fixed mold member 61, movable mold member 62, and a nesting member 63. As clearly shown in FIG. 18 and FIG. 19, the fixed mold member 61 constructs the inclined bock member 12 portion and the movable mold member 62 and the nesting member 11 construct the box-shaped block member 11 portion, respectively. In the present example, the movable mold member 62 is divided into two parts, but it can be divided into three or more parts. The fixed mold member 61 can also be divided into multiple parts such as a fixed part and a detachable part.

When the fixed mold member and the movable mold member are closed, the inner surface formed thereby defines a mold cavity. The inner surface includes a first mold surface (corresponding to the upper inclined surface of the package) and a second mold surface (corresponding to the lower inclined surface of the package) which are arranged opposite each other and the distance therebetween gradually decreases toward the gate. A recess (corresponding to the projection of the package) is defined at a portion where the first mold surface or the second mold surface comes into contact with the gate.

The metal mold for injection molding 60 has, for example as shown in FIG. 20, the projection 17 is extended on the tapered surface 15 of the inclined block member 12, and in one direction, the projection contributes a part of the outermost shape of the inclined block member 12, but the projection is preferably made into a shape so that it does not protrude out from the plane of the box-shaped mold member 11.

### (Gate 65)

The gate 65 of the metal mold for resin molding for resin molding the package body 10 is opened to the fixed mold member 61. The gate 65 is defined in a shape tapering in the resin injection direction, that is, tapering downwardly in FIG. 18 and FIG. 19. With this arrangement, the resin injection side of the gate can be opened widely to facilitate the resin injection. Also, when detaching the molded product, the resin JS1 filled and solidified in the gate 65 is ruptured to remove excess cured resin portion.

The diameter of the gate 65, that is, the smallest gate diameter Ød1 at the lowest portion of the gate 65 in the present specification, corresponds to the thickness D3 of the projection 17. That is, the gate diameter Ød1 is larger than the thickness D1 of the back surface and is substantially the same or smaller than the thickness D2 of the front surface 13. Accordingly, the inner surface of the fixed mold member 61 forms the first mold surface 66 or the second mold surface (a cut for tapered surface of the inclined block member) corresponding to the tapered surface 15 of the inclined block having a thickness gradually increasing from the back surface 14 side toward the front surface 13 side of the package body 10, and a recess 67 (a cut for tapered projection surface) corresponding to the tapered projection surface 16 having a thickness gradually increasing from the back surface side 13 toward the front surface side 13 which is more gradual than the inclination of the tapered surface 15 of the inclined block member, and continuous from the location on the tapered surface 15 of the inclined block member where the projection 17 to be arranged.

With this construction, resin molding can be performed extremely effectively. That is, conventionally, the gate diameter Ød1 cannot have been set larger then the thickness D1 of the back surface 14. Thus, a resin has to be injected at an elevated pressure so that a resin with viscosity can be injected to completely and uniformly fill the mold cavity in a short time. Particularly, as shown in FIGS. 1 and FIGS. 2, the narrowest part dt in the gap with the movable mold member 62, that is, the thickness dt of the edge portion of the lead frame 20 disposed between the fixed mold member 61 and the movable mold member 62, corresponding to the border portion of the tapered surface and the flat surface is extremely narrow (for example 60 µm). Therefore, in order to discharge the resin for molding the opening portion KK1 into the cavity 68 through the narrowest part, the injection speed of the molten resin needed to be increased, and/or the holding pressure after filling the resin is needed to be increased. Consequently, the resin may move in the gaps between the mold members, causing generation of resin burrs. In contrast, according to the present embodiment, as shown in FIGS. 21, the gate diameter Ød1 can be set larger, so that the resin injection pressure can be accordingly reduced. Thus, the resin can be filled in the thinner portions of the cavity even with a lower pressure, and generation of resin burrs can also be suppressed.

Here, dt is preferably set to be 1/4 or less of the height h of the mold cavity in the movable mold member 62. Also, at the movable mold member 62 side, a nesting member is disposed so that an opening KK1 for arranging a semiconductor element therein can be defined in the front surface side 13 of the semiconductor package 100 after formed by the injection molding. The thinnest part of the four walls defining the opening KK1 is preferably 0.1 mm or less. Moreover, the thickness of the semiconductor package 100 is preferably 2 mm or less. With this arrangement, stable injection molding can be performed even in a thin-type semiconductor package.

Here, the difference in size between the designed value and the molded products is neglected. But in practice, a difference may occur between the gate diameter Ød1 and the thickness D3 of the projection 17, due to presence or absence of primer or tolerance in the inner surface of the mold, and shrinkage of the resin or the like.

In the example of FIG. 16, one nesting member 63 is used, but two or more can be used according to the shape. Moreover, the positional relationship among the fixed mold member 61 and the movable mold member 62, and the nesting member 63 is not limited to the arrangement shown in FIG. 16, and the vertical or horizontal positional relationship can be appropriately changed according to the shape of the package to be molded or to the arrangement of the molding device. Moreover, the runner 64 and the gate 65 directing the molten resin JS are directly processed to the fixed mold member 61 in the example of FIG. 16, but they can be individual members.

### (Method of manufacturing Semiconductor Package)

A method of manufacturing a semiconductor package using a metal mold for injection molding will be described below with reference to FIG. 18 and FIG. 19. First, the fixed mold member 61, the movable mold member 62, and the nesting member 63 are closed so as to hold the lead frames 20 therebetween. With this arrangement, the mold cavity 68 which is an interspace is defined in the mold, and the lead frame 20 is held into a predetermined position in the cavity 68.

Thereafter, a molten resin JS is filled into the mold cavity 68 from the gate 65 through the runner 64. Then, after the molten resin JS injected in the mold cavity is cooled and solidified, the movable mold member 62 and the nesting member 63 are separated from the fixed mold member 61 to open the mold to release the molded semiconductor package. At this time, the gate 65 is formed in an inverse tapered shape as described above, so that the resin JS1 solidified in the gate 65 is sheared off when the movable mold member 62 is moved.

After the package body 10 is molded as described above, a light emitting element 30 is die-bonded in the opening KK1 of the package body 10 and the light emitting element 30 and the lead frame 20 are electrically connected by way of flip-chip bonding or wire bonding. Thereafter, the opening KK1 is molded with a light transmissive covering member 40 and the lead frame exposed outside of the package body 10 is cut and bent toward the package side, to obtain a light emitting device.

### Example 1

In Example 1, a metal mold for injection molding 60 was constructed with a fixed mold member 61, movable mold members 62, and a nesting member 63. The gate 65 formed in the fixed mold member 61 was tapered from the runner 64 side toward the mold cavity 68 side to the upper surface defining the mold cavity 68, then from the upper surface defining the mold cavity 68, the gate 65 was extended to the side surface of the fixed mold member 61 within a range not to extend over the outermost shape of the movable mold members 62. Thus, the gate 65 was extended to the mating surface 108 of the fixed molds 61, while maintaining a size in one direction for fabricating the outermost shape. A maximum gate diameter can be allowed in a metal mold for injection molding 60 with the gate 65 formed in such a shape, even in a case where a semiconductor package having the same shape thereof to be formed. The larger the gate diameter Ød1, the longer the time for the molten resin JS to cool and solidify, so that the metal mold for injection molding 60 can be the metal mold in which weld line and/or short shot is most unlikely to occur.

Particularly, as the package 200 for a side-view type light emitting device shown in FIG. 20, when the shape is such that the gate 65 is arranged directly above the thin wall portion 69 which has the thinnest thickness in the box-shape block member defining the opening, the molten resin will be filled earlier than other portions, so that the molten resin of a high temperature reaches the thin wall portion which enables effective prevention of weld line and/or short shot, which is most likely occur in this portion.

In the package thus molded, the thickness of the thin wall portion 69 shown in FIG. 20 can be reduced compare to the structures as shown in FIG. 1 etc. With a thinner thin wall portion 69, the size of the light emitting element to be mounted can be increased and the number of the light emitting elements to be mounted can also be increased. Typically, power consumption for a device is 600 mW or less and the required thickness of the product is 2 mm or less in the side-view type light emitting devices incorporated in middle and small size back lights mounted in a cell phone, a vehicle navigation system, a mobile computer, or the like. Under such limited conditions, the larger the light emitting element 30, the brighter the emission at the same electric power and thus advantageous.

The metal molds for injection molding described above are capable of forming the packages for semiconductors having sizes and complicated shapes which cannot be realized previously. Accordingly, the design freedom of the semiconductor devices is improved and thus space-saving and enhanced performance can be obtained. For example, in the side-view type light emitting devices and with the same thickness, a light emitting element of the largest possible size can be mounted, so that the brightest light emitting device can be obtained in the same size device. The backlight units or the like using the light emitting devices having increased brightness can obtain the same level of brightness as that of the conventional light emitting devices with a low electric power, and thus enables energy conservation. Also, when the same electric power is applied, enhanced brightness thereof allows the light emitting devices to be incorporated in a liquid crystal unit with higher color reproducibility.

As described above, according to the embodiments of the present invention, stable injection molding can be carried out, even in a narrow mold cavity, that is, a thin portion in a package body, while producing a thinner semiconductor package. In the above, exemplified is a formation of a light emitting device by using a mold, but this is surely not restrictive, and is applicable to any other thin type semiconductor packages and the injection molds thereof.

### INDUSTRIAL APPLICABILITY

The injection mold, the semiconductor package formed by using the mold, and the method of manufacturing the semiconductor package according to the present invention can be utilized as a side-view type of light emitting device, of the type in which light is emitted from a side surface toward a side surface of the package, and can be used not only in illumination devices used in image readers such as facsimile machines, copiers, and hand scanners, but also in various other illumination devices such as illumination light sources, backlight light sources for LED displays, portable telephones, and so forth, signaling devices, lighting switches, automotive brake lamps, various kinds of sensor, various kinds of indicator, and so on. Also, not only to the side-view type, the present invention can also be applied to a thin-type package for a surface mount type (SMD) of light emitting device. Further, not only to the light emitting device, the present invention can be suitably utilized as a thin-type semiconductor package for a photoelectric sensor, a light receiving element, and so forth.

It should be apparent to those with an ordinary skill in the art that while various preferred embodiments of the invention have been shown and described, it is contemplated that the invention is not limited to the particular embodiments disclosed, which are deemed to be merely illustrative of the inventive concepts and should not be interpreted as limiting the scope of the invention, and which are suitable for all modifications and changes falling within the scope of the invention as defined in the appended claims. The present application is based on Application No. 2008-016856 filed in Japan on January 28, 2008.

## Claims

1. A metal mold for injection molding (60) for molding a semiconductor package (100;100';200), the metal mold for injection molding (60) being closed to define a mold cavity (68), to enable molding a semiconductor package (100;100';200) by injecting a resin into the cavity (68), the metal mold for injection molding (60) comprising:
a fixed mold member (61); and a plurality of movable mold members (62);
wherein the fixed mold member (61) and the plurality of movable mold members (62) each has an inner surface capable of collectively defining the mold cavity (68) upon closing thereof;
**characterized in that**
the fixed mold member (61) or the movable mold members (62) have a gate (65) formed continuous to the inner surface thereof to inject a resin into the mold cavity (68); and **in that** the inner surface of the metal mold for injection (60) has a first mold surface (66) and a second mold surface being disposed facing each other and tapering toward the gate (65), the first mold surface (66) or the second mold surface having a recess at a portion to be in contact with the gate (65),
wherein a lead frame (20) is placed between the fixed mold member (61) and the movable mold members (62), and a narrowest gap between an end surface of the lead frame (20) and the inner surface of the movable mold members (62) is one fourth or less of a height of the mold cavity (68) defined by the movable mold members.

2. The metal mold for injection molding (60) according to claims 1, wherein a nesting member (63) is disposed in the cavity (68) of the movable mold member (62) side.

3. The metal mold for injection molding (60) according to claim 2, wherein the shortest distance between the inner surfaces of the movable mold members (62) and the nesting member (63) is 0.1 mm or less.

4. The metal mold for injection molding (60) according to any one of claims 1 to 3, wherein the diameter of the gate (65) in the thickness direction of the semiconductor package (100;100';200) is larger than the maximum thickness of a portion of the package where the gate (65) is not provided at the back side of the package, and the diameter of the gate (65) is approximately equal to or smaller than the maximum thickness of the package at the front side,

5. A method of manufacturing a semiconductor package (100;100;200) using a metal mold for injection molding according to claim 1, said manufactured semiconductor package having a package upper surface and a package lower surface tapering from the front side of the package toward the back side of the package, the method comprising:
a step of disposing a lead frame (20) at a predetermined position between the fixed mold member (61) and the movable molded members facing the fixed molded member;
a step of defining a mold cavity (68) by closing the mold members, wherein the fixed mold member (61) defines a gate (65) opened toward the back side of the package so as to inject a molten resin into the mold,
wherein an inner surface of the fixed mold member (61) defines a first mold surface (66) and a second mold surface being disposed facing each other and tapering toward the gate (65), and the first mold surface (66) or the second mold surface has a recess at a portion to be in contact with the gate (65)
and wherein said predetermined position is such that a narrowest gap between an end surface of the lead frame (20) and the inner surface of the movable mold members (62) is one fourth or less of a height of the of the mold cavity (68) defined by the movable mold members;
a step of filling the molten resin into the mold cavity (68) from the gate (65), from the fixed mold member (61) toward the movable mold members; and
a step of releasing the molded product after solidifying the molten resin.

6. The method of manufacturing according to claim 5, comprising disposing the lead frame on a nesting nest (63) prior to closing the mold members, said nesting member being disposed in the cavity of the movable mold members (62) side,
said predetermined position being such that the shortest distance between the inner surfaces of the movable mold members (62) and the nesting member (63) is 0.1 mm or less.

7. The method of manufacturing according to claim 5 or claim 6, wherein the diameter of the gate (65) in the thickness direction of the semiconductor package (100;100';200) is larger than the maximum thickness of a portion of the package where the gate (65) is not provided at the back side of the package, and the diameter of the gate (65) is approximately equal to or smaller than the maximum thickness of the package at the front side.

## Patentansprüche

1. Spritzguss-Metallform (60) zum Formen einer Halbleiterpackung (100; 100'; 200), wobei die Spritzguss-Metallform (60) geschlossen ist, um eine Formkavität (68) zu definieren, um das Formen einer Halbleiterpackung (100; 100'; 200) durch Einspritzen eines Harzes in die Kavität (68) zu ermöglichen, wobei die Spritzguss-Metallform (60) umfasst:
ein festes Formglied (61), und
mehrere bewegliche Formglieder (62),
wobei das feste Formglied (61) und die mehreren beweglichen Formglieder (62) jeweils eine innere Oberfläche aufweisen, die in der Lage sind, gemeinsam nach deren Schließen die Formkavität (68) zu definieren,
**dadurch gekennzeichnet, dass**
das feste Formglied (61) oder die beweglichen Formglieder (62) einen Angusskanal (65) aufweisen, der mit der inneren Oberfläche davon durchgehend ausgebildet ist, um ein Harz in die Formkavität (68) einzuspritzen; und dadurch, dass die innere Oberfläche der Spritzguss-Metallform (60) eine erste Formoberfläche (66) und eine zweite Formoberfläche aufweist, die einander zugewandt und in Richtung des Angusskanals (65) zulaufend angeordnet sind, wobei die erste Formoberfläche (66) oder die zweite Formoberfläche an einem Abschnitt, der mit dem Angusskanal (65) in Berührung sein soll, eine Ausnehmung aufweist,
wobei zwischen dem festen Formglied (61) und den beweglichen Formgliedern (62) ein Systemträger (20) angeordnet ist und ein schmalster Zwischenraum zwischen einer Endoberfläche des Systemträgers (20) und der inneren Oberfläche der beweglichen Formglieder (62) ein Viertel oder weniger einer Höhe der Formkavität (68) ist, die durch die beweglichen Formglieder definiert wird.

2. Spritzguss-Metallform (60) nach Anspruch 1, wobei ein Einschubglied (63) in der Kavität (68) der Seite des beweglichen Formglieds (62) angeordnet ist.

3. Spritzguss-Metallform (60) nach Anspruch 2, wobei der kürzeste Abstand zwischen den inneren Oberflächen der beweglichen Formglieder (62) und dem Einschubglied (63) 0,1 mm oder weniger beträgt.

4. Spritzguss-Metallform (60) nach einem beliebigen der Ansprüche 1 bis 3, wobei der Durchmesser des Angusskanals (65) in der Dickenrichtung der Halbleiterpackung (100; 100'; 200) größer als die maximale Dicke eines Abschnitts der Packung ist, wo der Angusskanal (65) nicht an der Rückseite der Packung vorgesehen ist, und der Durchmesser des Angusskanals (65) annähernd gleich der maximalen oder kleiner als die maximale Dicke der Packung an der Vorderseite ist.

5. Verfahren zum Herstellen einer Halbleiterpackung (100; 100'; 200) mittels einer Spritzguss-Metallform nach Anspruch 1, wobei die hergestellte Halbleiterpackung eine obere Packungsoberfläche und eine untere Packungsoberfläche aufweist, die von der Vorderseite der Packung in Richtung der Rückseite der Packung zulaufen, wobei das Verfahren umfasst:
einen Schritt des Anordnens eines Systemträgers (20) an einer vorgegebenen Position zwischen dem festen Formglied (61) und den beweglichen Formgliedern, die dem festen Formglied zugewandt sind,
einen Schritt des Definierens einer Formkavität (68) durch Schließen der Formglieder, wobei das feste Formglied (61) einen Angusskanal (65) definiert, der in Richtung der Rückseite der Packung geöffnet ist, um ein geschmolzenes Harz in die Form einzuspritzen,
wobei eine innere Oberfläche des festen Formglieds (61) eine erste Formoberfläche (66) und eine zweite Formoberfläche definiert, die einander zugewandt und in Richtung des Angusskanals (65) zulaufend angeordnet sind, und die erste Formoberfläche (66) oder die zweite Formoberfläche eine Ausnehmung an einem Abschnitt aufweist, der mit dem Angusskanal (65) in Berührung sein soll,
und wobei die vorgegebene Position derart ist, dass ein schmalster Zwischenraum zwischen einer Endoberfläche des Systemträgers (20) und der inneren Oberfläche der beweglichen Formglieder (62) ein Viertel oder weniger einer Höhe der Formkavität (68) ist, die durch die beweglichen Formglieder definiert wird,
einen Schritt des Füllens des geschmolzenen Harzes in die Formkavität (68) von dem Angusskanal (65), von dem festen Formglied (61) in Richtung der beweglichen Formglieder, und
einen Schritt des Entformens des Spritzlings nach dem Erstarren des geschmolzenen Harzes.

6. Herstellungsverfahren nach Anspruch 5, umfassend das Anordnen des Systemträgers auf einem Einschubglied (63) vor dem Schließen der Formglieder, wobei das Einschubglied in der Kavität der Seite der beweglichen Formglieder (62) angeordnet ist,
wobei die vorgegebene Position derart ist, dass der kürzeste Abstand zwischen den inneren Oberflächen der beweglichen Formglieder (62) und dem Einschubglied (63) 0,1 mm oder weniger beträgt.

7. Herstellungsverfahren nach Anspruch 5 oder 6, wobei der Durchmesser des Angusskanals (65) in der Dickenrichtung der Halbleiterpackung (100; 100'; 200) größer als die maximale Dicke eines Abschnitts der Packung ist, wo der Angusskanal (65) nicht an der Rückseite der Packung vorgesehen ist, und der Durchmesser des Angusskanals (65) annähernd gleich der maximalen oder kleiner als die maximale Dicke der Packung an der Vorderseite ist.

## Revendications

1. Moule métallique pour moulage par injection (60) afin de mouler un boîtier de semi-conducteur (100 ; 100' ; 200), le moule métallique pour moulage par injection (60) étant fermé pour définir une cavité de moule (68) afin de permettre de mouler un boîtier de semi-conducteur (100 ; 200' ; 200) en injectant une résine dans la cavité (68), le moule métallique pour moulage par injection (60) comprenant :
un élément de moule fixe (61) ; et
une pluralité d'éléments de moule mobiles (62) ;
dans lequel l'élément de moule fixe (61) et la pluralité d'éléments de moule mobiles (62) ont chacun une surface interne pouvant définir collectivement la cavité de moule (68) suite à leur fermeture ;
**caractérisé en ce que** :
l'élément de moule fixe (61) ou les éléments de moule mobiles (62) ont une attaque de coulée (65) formée de manière continue jusqu'à sa surface interne afin d'injecter une résine dans la cavité de moule (68) et **en ce que** la surface interne du moule métallique pour injection (60) a une première surface de moule (66) et une seconde surface de moule qui sont disposées en face l'une de l'autre et se rétrécissant progressivement vers l'attaque de coulée (65), la première surface de moule (66) ou la seconde surface de moule ayant un évidement au niveau d'une partie pour être en contact avec l'attaque de coulée (65),
dans lequel une grille de connexion (20) est placée entre l'élément de moule fixe (61) et les éléments de moule mobiles (62), et l'espace le plus étroit entre une surface d'extrémité de la grille de connexion (20) et la surface interne des éléments de moule mobiles (62) représente un quart ou moins d'une hauteur de la cavité de moule (68) définie par les éléments de moule mobiles.

2. Moule métallique pour moulage par injection (60) selon la revendication 1, dans lequel un élément d'emboîtement (63) est disposé dans la cavité (68) du côté de l'élément de moule mobile (62).

3. Moule métallique pour moulage par injection (60) selon la revendication 2, dans lequel la distance la plus courte entre les surfaces internes des éléments de moule mobiles (62) et l'élément d'emboîtement (63) est de 0,1 mm ou moins.

4. Moule métallique pour moulage par injection (60) selon l'une quelconque des revendications 1 à 3, dans lequel le diamètre de l'attaque de coulée (65) dans le sens de l'épaisseur du boîtier de semi-conducteur (100 ; 100' ; 200) est supérieur à l'épaisseur maximale d'une partie du boîtier où l'attaque de coulée (65) n'est pas prévue du côté arrière du boîtier, et le diamètre de l'attaque de coulée (65) est approximativement égal ou inférieur à l'épaisseur maximale du boîtier au niveau du côté avant.

5. Procédé pour fabriquer un boîtier de semi-conducteur (100 ; 100' ; 200) utilisant un moule métallique pour moulage par injection selon la revendication 1, ledit boîtier de semi-conducteur manufacturé ayant une surface supérieure de boîtier et une surface inférieure de boîtier se rétrécissant progressivement à partir du côté avant du boîtier vers le côté arrière du boîtier, le procédé comprenant :
une étape consistant à disposer une grille de connexion (20) dans une position prédéterminée entre l'élément de moule fixe (61) et les éléments de moule mobiles faisant face à l'élément de moule fixe ;
une étape consistant à définir une cavité de moule (68) en fermant les éléments de moule, dans lequel l'élément de moule fixe (61) définit une attaque de coulée (65) ouverte vers le côté arrière du boîtier afin d'injecter une résine en fusion dans le moule,
dans lequel une surface interne de l'élément de moule fixe (61) définit une première surface de moule (66) et une seconde surface de moule qui sont disposées en vis-à-vis et se rétrécissant progressivement vers l'attaque de coulée (65), et la première surface de moule (66) ou la seconde surface de moule a un évidement au niveau d'une partie destinée à être en contact avec l'attaque de coulée (65),
et dans lequel ladite position prédéterminée est telle que l'espace le plus étroit entre une surface d'extrémité de la grille de connexion (20) et la surface interne des éléments de moule mobiles (62) représente un quart ou moins d'une hauteur de la cavité de moule (68) définie par les éléments de moule mobiles ;
une étape consistant à verser la résine en fusion dans la cavité de moule (68) à partir de l'attaque de coulée (65), de l'élément de moule fixe (61) vers les éléments de moule mobiles ; et
une étape consistant à démouler le produit moulé après solidification de la résine en fusion.

6. Procédé de fabrication selon la revendication 5, comprenant l'étape consistant à disposer la grille de connexion sur un élément d'emboîtement (63) avant de fermer les éléments de moule, ledit élément d'emboîtement étant disposé dans la cavité du côté des éléments de moule mobiles (62),
ladite position prédéterminée étant telle que la distance la plus courte entre les surfaces internes des éléments de moule mobiles (62) et l'élément d'emboîtement (63) est de 0,1 mm ou moins.

7. Procédé de fabrication selon la revendication 5 ou la revendication 6, dans lequel le diamètre de l'attaque de coulée (65) dans le sens de l'épaisseur du boîtier de semi-conducteur (100 ; 100' ; 200) est supérieure à l'épaisseur maximum d'une partie du boîtier où l'attaque de coulée (65) est prévue au niveau du côté arrière du boîtier, et le diamètre de l'attaque de coulée (65) est approximativement égal ou inférieur à l'épaisseur maximum du boîtier au niveau du côté avant.
